Europäisches Patentamt

(19) European Patent Office

Office européen des brevets

(11) Numéro de publication : **0 145 542**
**B1**

(12) **FASCICULE DE BREVET EUROPÉEN**

(45) Date de publication du fascicule du brevet :
17.05.89

(21) Numéro de dépôt : 84402226.9

(22) Date de dépôt : 06.11.84

(51) Int. Cl.⁴ : **H 05 K   7/12**

(54) **Connecteur à force d'insertion nulle pour support rectangulaire de circuit, et pince de fermeture pour un tel connecteur.**

(30) Priorité : 10.11.83 FR 8317912

(43) Date de publication de la demande :
19.06.85 Bulletin 85/25

(45) Mention de la délivrance du brevet :
17.05.89 Bulletin 89/20

(84) Etats contractants désignés :
DE FR GB IT

(56) Documents cités :
EP—A— 0 118 346
EP—A— 0 146 242
DE—A— 2 539 379
GB—A—   935 565
US—A— 4 172 626
US—A— 4 235 500
MIL-S-38533

(73) Titulaire : **SOCAPEX**
**10 bis, quai Léon Blum**
**F-92153 Suresnes (FR)**

(72) Inventeur : **Bricaud, Hervé**
**THOMSON-CSF SCPI 173, bld Haussmann**
**F-75379 Paris Cedex 08 (FR)**
Inventeur : **Rouffy, Jean-Claude**
**THOMSON-CSF SCPI 173, bld Haussmann**
**F-75379 Paris Cedex 08 (FR)**
Inventeur : **L'Henaff, Patrick**
**THOMSON-CSF SCPI 173, bld Haussmann**
**F-75379 Paris Cedex 08 (FR)**

(74) Mandataire : **Hasenrader, Hubert et al**
**Cabinet BEAU DE LOMENIE 55, rue d'Amsterdam**
**F-75008 Paris (FR)**

EP 0 145 542 B1

Jouve, 18, rue St-Denis, 75001 Paris, France

## Description

La présente invention concerne un connecteur à force d'insertion nulle pour support rectangulaire de circuit muni de zones de contact disposées sur l'une au moins de ses deux faces, comportant d'une part une embase rectangulaire munie de contacts souples sur lesquels viennent s'appuyer les zones de contact correspondantes de la face inférieure du support et d'autre part une pince constituée d'un cadre rectangulaire venant s'appuyer sur la partie supérieure du support, de manière à maintenir la continuité électrique entre les zones de contact et les contacts souples, ladite pince étant fixée à l'embase par des crochets disposés aux quatre angles du cadre rectangulaire et coopérant avec des logements correspondants de l'embase.

Un tel type de connecteur ainsi que la pince venant se fixer sur l'embase de celui-ci est décrit dans la norme américaine MIL S 38533. On pourra également se reporter à la demande française FR-A 2 541 827 intitulée « connecteur comprenant au moins un contact présentant un bras élastiquement déformable » déposée le 25 février 1983 au nom de la Demanderesse et dont la description est incorporée dans la présente demande à titre de référence.

L'objet de FR-A 2 541 827 correspond à la demande EP-A-0 118 346, qui, entre autres, désigne les états contractants DE, GB et IT désignés aussi dans la présente demande et tombe sous l'article 54(3) CBE en ce qui concerne les revendications 1 à 7 et l'article 54(2) en ce qui concerne les suivantes.

La demande EP-A-0 118 346 montre une pince pour connecteur du même type, ayant deux bras d'appui disposés en vis-à-vis et reliés par deux bras de traverse, chaque bras d'appui comportant sensiblement en son milieu une zone d'appui à laquelle se raccordent deux demi-bras symétriques. Cependant les deux demi-bras symétriques ne forment pas à l'état libre un V.

Ce type de connecteur est à force d'insertion nulle c'est-à-dire que le support de circuit (plus connu sous l'appellation anglo-saxonne « Chip Carrier ») vient se positionner sans effort d'insertion sur une embase rectangulaire munie de rangées de contacts souples. Après insertion du chip carrier, on vient fermer le connecteur en verrouillant la pince sur l'embase.

Actuellement, sont développés des « chips-carrier » comportant d'une part des connexions périmétriques disposées sur la face inférieure et d'autre part au moins une rangée de connexions périmétriques disposées sur la face supérieure du chip-carrier. La présence de connexions sur la face supérieure du chip-carrier, permet de fixer la puce semi-conductrice directement sur celui-ci.

La pince telle que définie dans cette norme MIL comporte un cadre rectangulaire constitué de quatre bras orthogonaux, lesdits bras étant situés dans un même plan et se prolongeant dans les angles de raccordement par des crochets venant s'encastrer dans des logements correspondants de l'embase. Une telle disposition implique que lorsque le chip-carrier comporte une rangée de connexions périmétriques sur sa face supérieure, le cadre métallique utilisé pour la pince provoque des courts-circuits entre les différents contacts de la face supérieure du chip-carrier. De plus, les réalisations actuellement disponibles sur le marché ont de par leur structure un encombrement qui ne leur permet pas de répondre à la norme citée plus haut.

Un connecteur à force d'insertion nulle, du type selon l'invention est également connu du EP-A-0 146 242 qui entre dans l'état de la technique visé à l'article 54(3) CBE en ce qui concerne les revendications 1 à 7.

Ce connecteur connu comporte une pince constituée d'un cadre rectangulaire venant s'appuyer sur la partie supérieure du support de manière à maintenir la continuité électrique entre les zones de contact et les contacts souples, ladite pince étant fixée à l'embase par deux pivots et par deux crochets disposés aux quatre angles du cadre rectangulaire et coopérant avec des logements correspondants de l'embase. La pince comporte deux bras d'appui disposés en vis-à-vis et reliés par deux bras de traverse, chaque bras d'appui comportant, sensiblement en son milieu, une zone d'appui à laquelle se raccordent deux demi-bras symétriques formant à l'état libre un V, l'extrémité desdits demi-bras étant à un niveau supérieur à la zone d'appui lorsque la pince est à l'état libre et sensiblement au même niveau que celle-ci lorsque la pince est fixée sur l'embase.

Un tel connecteur présente l'inconvénient d'être plus compliqué que celui de l'invention tant au point de vue de la fabrication de la pince que de celui du montage de celle-ci sur l'embase.

L'invention permet d'éviter les inconvénients de ces dispositifs connus et propose un connecteur à force d'insertion nulle pour support rectangulaire de circuit ledit support étant muni de zones de contact disposées sur l'une au moins de ses deux faces et ledit connecteur comportant d'une par une embase rectangulaire munie de contacts souples sur lesquels viennent s'appuyer les zones de contact correspondantes de la face inférieure du support et d'autre part une pince constituée d'un cadre rectangulaire venant s'appuyer sur la partie supérieure du support de manière à maintenir la continuité électrique entre les zones de contact et les contacts souples, ladite pince étant fixée à l'embase par des crochets disposés aux quatre angles du cadre rectangulaire qui coopèrent avec des logements correspondants de l'embase et comportant au moins deux bras d'appui disposés en vis-à-vis et reliés par deux bras de traverse, chaque bras d'appui étant constitué sensiblement en son milieu d'une zone d'appui à laquelle se raccordent deux demi-bras symétriques formant à l'état libre un V, l'extrémité desdits demi-bras située à proximité des crochets étant à un niveau supérieur à la zone d'appui lorsque la pince est à l'état libre et sensiblement au même niveau que celle-ci lorsque la pince est fixée sur l'embase.

L'invention propose également un dispositif d'encliquetage de la pince sur l'embase selon l'objet de la revendication 9. De préférence, les demi-bras ont une forme d'égale résistance, ce qui se traduira généralement par le fait que les demi-bras sont plus larges à proximité de la zone d'appui qu'à proximité des crochets.

Selon un mode préférentiel de réalisation, la zone d'appui est formée par une excroissance située sur le bord interne de la zone d'appui du bras d'appui correspondant permettant une force d'appui de la pince sur le support supérieure à celle des contacts de l'embase sur ledit support, le bord de celui-ci venant en butée contre la plate-forme d'appui inférieure de la cavité de l'embase.

De préférence, l'un au moins des crochets, qui sont constitués d'une première partie située dans le prolongement des demi-bras, une seconde partie sensiblement orthogonale à la première et une troisième partie sensiblement orthogonale à la seconde et coopérant avec un logement de l'embase pour maintenir la fermeture de la pince, comporte un téton dans le prolongement de la première partie ménageant une ouverture entre la seconde partie et le téton permettant l'introduction d'un outil plat venant en butée contre la troisième partie, l'ouverture du crochet s'effectuant à l'aide de l'outil plat prenant appui sur le téton après son introduction dans l'ouverture.

Dans un mode préférentiel de réalisation, le connecteur selon l'invention est caractérisé en ce que les bras de traverse de la pince ont une forme incurvée, dans le même sens que les bras d'appui, le bord interne desdits bras étant, lorsque la pince est à l'état libre, à un niveau inférieur à celui du bord extérieur du bras correspondant.

La pince décrite ci-dessus peut aussi être utilisée pour fixer directement sur la face supérieure du chip-carrier un dispositif de refroidissement tel qu'un radiateur à ailettes ou un bloc de refroidissement par circulation de liquide caloporteur. Lorsque le dispositif de refroidissement est constitué par un radiateur comportant essentiellement des ailettes verticales et deux flasques de fixation horizontaux, la pince de la présente invention permet d'utiliser un seul type de radiateur, quelle que soit la direction de soufflage, les bras de traverse ou les bras d'appui servant respectivement de moyen de verrouillage du radiateur sur le chip-carrier, selon la direction de soufflage. D'autre part, le radiateur est, dans ce cas, directement en contact avec la face supérieure du chip-carrier, sans utilisation de colle et de joint isolant comme avec les connecteurs de l'art antérieur. On obtient donc une meilleure répartition thermique entre le radiateur et le chip-carrier. De plus, on obtient un verrouillage fiable sans problème de contraintes thermo-mécaniques engendrées par les différences de coefficient de dilatation thermique entre l'alumine et l'aluminium du radiateur (rapport > 4 entre les deux).

Selon un autre mode de réalisation, chaque bras d'appui comporte sur le bord externe de la zone d'appui, un téton permettant la fixation d'un dispositif de refroidissement. Dans ce cas, le dispositif de refroidissement est, de préférence, constitué par un radiateur à ailettes horizontales se prolongeant par une embase dimensionnée de manière à pouvoir s'insérer dans l'ouverture centrale de la pince. Avec ce type de radiateur, la direction de soufflage n'a plus à être prise en compte. D'autre part, la dimension des ailettes n'est pas limitée à l'ouverture centrale de la pince, puisque seule l'embase du radiateur doit traverser l'ouverture centrale.

De préférence, l'embase comporte aux quatre coins des parties en relief situées en retrait du pourtour extérieur de l'embase et possédant une rampe sur laquelle vient glisser le crochet correspondant de la pince lors de l'accouplement pince-embase, ladite rampe se terminant par une partie plane sur laquelle vient s'appuyer la troisième partie du crochet correspondant.

Grâce à la forme particulière de l'embase, il est possible d'utiliser un dispositif d'encliquetage de la pince sur l'embase pouvant être utilisé manuellement ou automatiquement. Ce dispositif est constitué par un couvercle de forme parallélépipédique de manière à s'emboîter sur l'embase, ledit couvercle comportant intérieurement au niveau des coins, des bossages venant en appui contre les quatre angles de la pince lors de l'encliquetage. Avec ce dispositif d'encliquetage, on exerce donc une pression perpendiculaire et uniforme sur les quatre angles de la pince. Selon une variante de réalisation, le fond du couvercle présente une ouverture centrale permettant le passage du dispositif de refroidissement.

L'invention sera mieux comprise à l'aide des exemples de réalisation suivants, donnés à titre non limitatif, conjointement avec les figures qui représentent :

la figure 1, une vue du connecteur selon l'invention ;

les figures 2 à 5, différentes vues de la pince du connecteur selon l'invention ;

la figure 6, une vue éclatée du connecteur selon l'invention, lorsqu'un radiateur à ailettes verticales est verrouillé à l'aide de la pince ;

la figure 7, une vue d'un connecteur selon l'invention utilisant une pince modifiée pour recevoir un radiateur à ailettes horizontales, et

la figure 8, un dispositif d'encliquetage automatique de la pince sur l'embase.

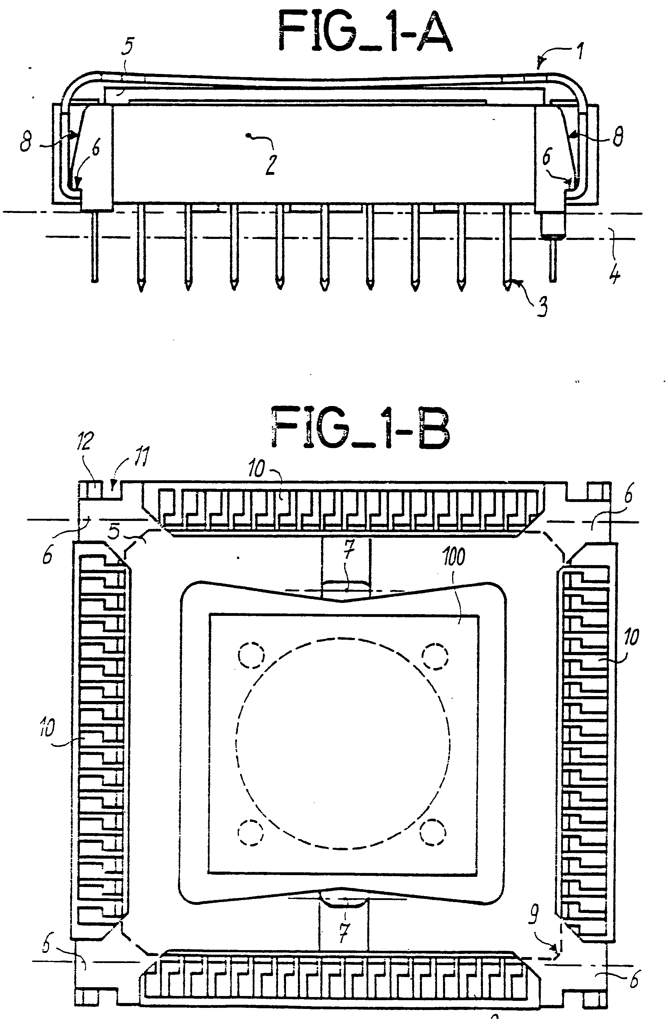

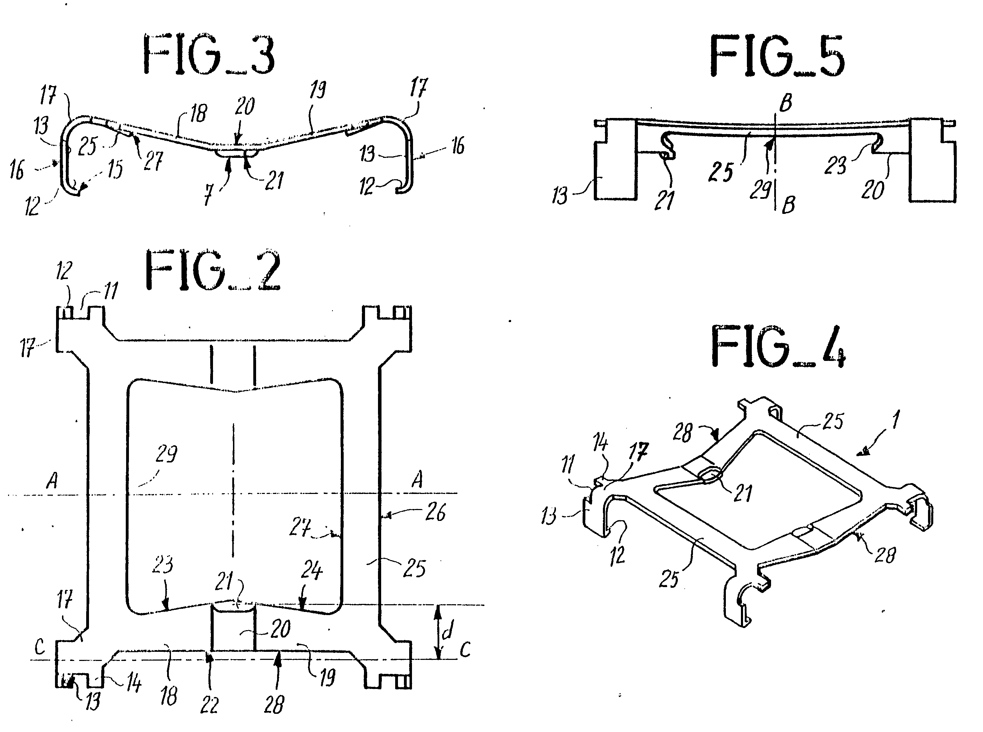

Les figures 1A et 1B montrent respectivement une vue de côté et une vue de dessus du connecteur selon l'invention, fermé sur un chip-carrier 5. Celui-ci est positionné, sans effort d'insertion, en appui sur la rangée de contacts périmétriques 3 dans l'embase 2 du connecteur. Le corps, moulé en matière plastique, de l'embase 2 présente une cavité dont le contour interne est à l'image du contour externe du chip-carrier 5. Lors du positionnement du chip-carrier 5 dans l'embase 2, il faut donc mettre en concordance les coins de détrompage respectifs 8 et 9. (La plate-forme d'appui inférieure de la cavité de l'embase n'est pas représentée sur la figure). Le connecteur est ensuite fermé en verrouillant la pince 1 sur l'embase 2. Ce verrouillage est réalisé en exerçant une pression au niveau des quatre angles de la pince 1. Sous cette pression, les becquets 15 (ou troisième partie) des crochets 16 (voir figures 2 à 5) de la pince glissent sur les pentes de guidage 8 de l'embase jusqu'à l'encliquetage des becquets 15 dans les logements plans correspondants 6 de l'embase 2. Au cours de l'opération de verrouillage, les bras d'appui 28 de la pince se déforment de façon élastique en exerçant une force d'appui sur le chip-carrier ; sous l'action de cette force d'appui, le chip-carrier s'enfonce dans la cavité interne de l'embase en déformant de façon élastique les contacts 3 de l'embase jusqu'à ce que le chip-carrier bute contre la plate-forme d'appui inférieure de la cavité. Pour plus de détail sur l'embase d'un tel connecteur et les contacts utilisables, on se reportera à la demande de brevet français FR-A 2 541 827 citée plus haut, dont la description est incorporée à la présente demande.

La forme et la structure de la pince 1 ont été déterminées de façon à ce qu'après encliquetage, la force d'appui exercée par la pince sur le chip-carrier soit égale ou supérieure à la somme des forces d'appui de l'ensemble des contacts 3 sur les plots 33 du chip-carrier.

Par ailleurs, la pince doit permettre, après verrouillage, l'accès à l'arrière 10 des contacts pour un éventuel test électrique en fonctionnement. Enfin, elle doit présenter une ouverture centrale suffisamment large pour laisser le passage à un éventuel radiateur de refroidissement encliqueté ou fixé directement sur le chip-carrier et schématisé par le contour 100, comme cela sera expliqué de manière plus détaillée ci-après.

Un exemple de pince utilisable dans un connecteur selon l'invention va maintenant être décrit en se reportant aux figures 2 à 5. La pince comporte un cadre sensiblement rectangulaire constitué de quatre bras orthogonaux, deux bras d'appui 28 et deux bras de traverse 25. Les bras d'appui 28 présentent en leur milieu une face d'appui 7, au niveau de laquelle se raccordent les deux demi-bras symétriques 18 et 19 en formant à l'état libre un V ouvert à environ 155°. Les demi-bras 18 et 19 ont de préférence une forme « d'égale résistance », c'est-à-dire que leur largeur décroît linéairement de la zone d'appui 20 à leur extrémité. La forme en V des bras d'appui est favorable à l'encombrement minimum en hauteur du connecteur : en effet à l'état verrouillé, du fait de la déformation élastique des bras d'appui, l'angle du V est proche de 180° (légèrement inférieur), ce qui réduit son encombrement en hauteur à une valeur proche de son épaisseur (voir vue de profil, figure 1A). Par ailleurs, les variations d'épaisseur dues aux tolérances de fabrication du chip-carrier sont absorbées par une déformation élastique plus ou moins prononcée de la forme en V des bras d'appui ; et l'encombrement total en hauteur du connecteur est constant puisqu'il est donné par le sommet des arrondis 17 (ou première partie des crochets 16) de la pince 1.

La face d'appui 7 est préférentiellement formée par une excroissance 21 de la zone d'appui 20 déportée du côté des bords internes 23 et 24 du bras d'appui. (Une seule excroissance est représentée sur la figure 2, le bras supérieur de la pince étant selon une variante sans excroissance). Cette excroissance 21 peut être obtenue par emboutissage sous forme d'un bossage, ou par l'apport d'une pièce complémentaire soudée ou collée éventuellement isolante électriquement sur le plat central 20 (ou zone d'appui) du bras d'appui 28. Le déport du point d'appui crée un phénomène de torsion du bras d'appui 28 qui a pour effet de renforcer la force d'appui déjà due à la flexion du bras d'appui 28. Par ailleurs, ce déport permet également le verrouillage du chip-carrier présentant au moins une rangée de connexions périmétriques sur sa face supérieure, sans mettre en court-circuit plusieurs de ces plots.

Les bras de traverse 25 jouent un rôle d'entretoise entre les deux bras d'appui 28. Cependant, lorsque le point d'appui 7 des bras d'appui 28 est déporté, ils exercent la réaction nécessaire au couple de torsion subit par les bras d'appui 28 et participent de cette façon à la force d'appui totale de la pince 1 sur le chip-carrier 5 ; il est alors avantageux de donner une forme incurvée aux bras de traverse 25, au moment de leur fabrication, pour éviter que leur déformée s'ajoute à l'encombrement total en hauteur du connecteur verrouillé.

Les crochets 16 de la pince sont raccordés aux quatre angles du cadre, dans le prolongement des bras d'appui 28, par l'intermédiaire des arrondis 17. Lors du verrouillage, l'ouverture du V des bras d'appui 18 tend à refermer les crochets vers l'intérieur des logements de l'embase : ce phénomène contribue au bon encastrement des becquets 15 dans ces logements. Le déverrouillage ne nécessite pas d'outil spécifique : il suffit d'introduire par exemple une lame de tournevis par l'ouverture 11 jusqu'à ce que l'extrémité de la lame vienne en butée sur la face d'arrêt 12 du crochet et d'exercer une pression sur la face d'arc-boutement 13 (ou seconde partie des crochets 16) en prenant le téton 14 comme appui de bras de levier. L'arrondi de raccordement 17 fournit l'élasticité nécessaire au dégagement du becquet 15 de son logement. La face d'arrêt 12 est un élément de sécurité qui évite à la lame de tournevis de glisser et de venir endommager les pistes de la carte électronique 4, situées sous le connecteur lors du déverrouillage.

En position verrouillée, les crochets 16 sont de préférence légèrement en retrait à l'intérieur des logements de l'embase (voir figure 1A). De cette façon, les crochets 16 ne sortent pas de l'encombrement maximal de l'embase 2 lorsque les becquets 15 sont dégagés de leur logement pour déverrouiller la pince, et il est ainsi possible d'équiper la carte électronique 4 de plusieurs connecteurs montés au contact l'un de l'autre sur tous les côtés.

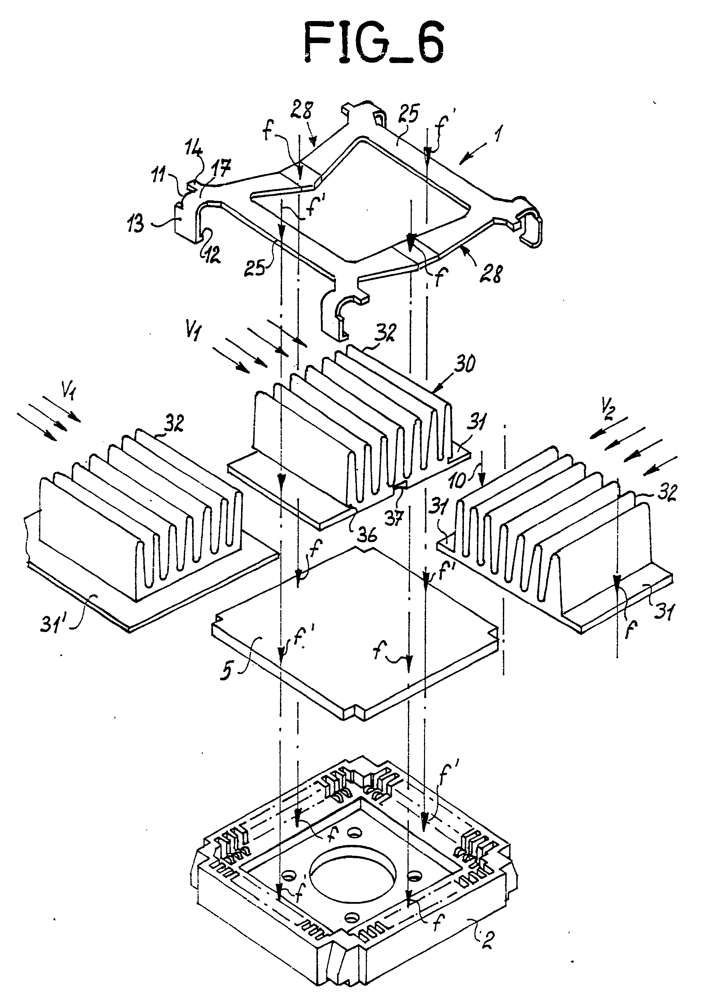

Sur la figure 5, l'axe BB sépare, sur la gauche une variante de la pince avec bossage 21 déporté et sur la droite de la figure un bras d'appui avec une zone 20 plane.

Sur la figure 2, l'axe CC représente approximativement l'axe selon lequel les crochets 16 prennent appui sur la zone correspondante de l'embase. Lorsque la partie plane 20 du bras d'appui 28 comporte un bossage 21, celui-ci est déporté d'une distance d par rapport à l'axe CC. On constate alors que de cette manière, on augmente très sensiblement (d'un facteur 2 ou 3) la force d'appui de la pince sur le chip-carrier.

Le gain obtenu sur la force d'appui totale par le déport du point d'appui permet :

de réduire d'autant la largeur des bras, pour dégager au maximum l'ouverture centrale de la pince nécessaire au passage d'un dispositif de refroidissement tel qu'un radiateur,

de connecter le support de circuit sur une embase 2 comportant un nombre élevé de contacts 3 présentant eux-mêmes une force d'appui individuelle élevée pour assurer une résistance électrique de contact faible et stable.

Il est à noter également que la forme « d'égale résistance » de la découpe des bras d'appui 28 (les côtés 22, 23, 24 sont rectilignes) permet de réduire au maximum la longueur de ces bras en optimisant la répartition des contraintes engendrées par la force d'appui totale. Ceci permet un faible encombrement extérieur du connecteur (en vue de dessus, voir figure 1A) pour un format donné du support de circuit 5.

Une variante avantageuse de l'invention consiste à préformer, au moment de la réalisation de la pièce, le bras de traverse 25 de façon à lui donner une forme légèrement incurvée en arc de cercle dans le sens opposé à la déformée résultant de la fermeture de la pince. Il est possible, en choisissant convenablement la précontrainte des deux bras de traverse 25, d'établir sur le support de circuit un point d'appui supplémentaire au milieu de chacun de ces deux bras de traverse. Ces deux points d'appui supplémentaires s'ajoutent aux deux points d'appui principaux 7 exercés par les bras d'appui 28, et sont situés sur la deuxième médiane du support de circuit 5. Du fait du profil des bras d'appui 28 (voir figure 1B), ces points d'appui supplémentaires 29 sont déportés vers le bord interne 27 des bras de traverse 25. Cette variante peut donc être également utilisée avec des chips-carrier bon marché ayant des plots de connexion sur leurs deux faces.

D'autre part, comme représenté sur la figure 6, l'ouverture centrale présentée par la pince permet le passage d'un dispositif de refroidissement 30 en appui directement sur le chip-carrier 5. Le dispositif de refroidissement est, dans le mode de réalisation représenté, constitué par un radiateur à ailettes verticales 32 comportant deux flasques de fixation horizontaux 31, ce type de radiateur est généralement réalisé par un profilé extrudé. Le radiateur doit être positionné pour que les ailettes 32 soient parallèles à la direction de soufflage. Ainsi, lorsque la direction de soufflage est perpendiculaire aux bras d'appui 28, à savoir lorsque le soufflage est réalisé selon $V_1$, le radiateur est positionné de telle sorte que les flasques horizontaux 31 soient maintenus en position par les bras de traverse 25. Dans ce cas, si les bras de traverse sont incurvés, la pince exerce une pression sur le chip-carrier 5 non seulement par les bras d'appui 28 mais aussi par les bras de traverse 25 appuyant sur les flasques 31, comme cela est symbolisé par les flèches verticales en trait fort f et f'. On obtient donc une pression uniforme du chip-carrier sur les contacts électriques périphériques de l'embase. Si la direction de soufflage est parallèle aux bras d'appui 28, à savoir si le soufflage est réalisé selon $V_2$, le radiateur est alors positionné de telle sorte que les flasques horizontaux 31 soient maintenus en position par les bras d'appui 28 comme représenté sur la partie droite de la figure 6. Selon une variante de réalisation, les ailettes verticales sont entourées par un flasque périphérique 31' qui de plus assure un contact thermique amélioré. Ce mode de réalisation est représenté sur la partie gauche de la figure 6. De plus, pour permettre le maintien du radiateur sur la pince démontée, on prévoit soit des gorges 36, soit des encoches 37 comme représenté sur la figure 6. La pointe de la zone d'appui peut venir s'encliqueter dans ces parties. Les faces latérales du radiateur sont munies de pentes pour faciliter l'encliquetage des pointes dans ces gorges ou encoches. Il est donc possible avec ce type de connecteur d'utiliser un seul type de radiateur quelle que soit la direction de soufflage.

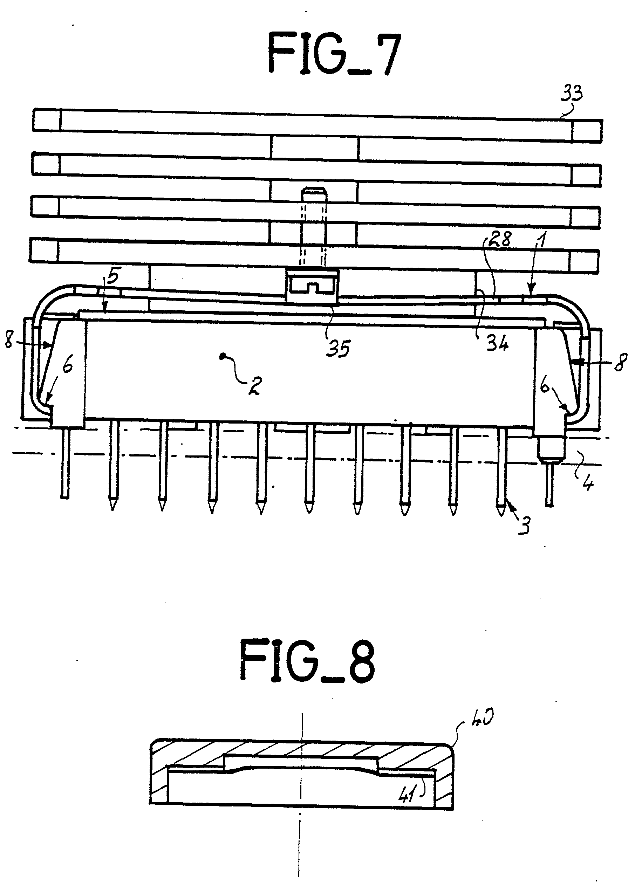

Sur la figure 7, on a représenté un autre type de dispositif de refroidissement 30. Ce dispositif de refroidissement est constitué de plusieurs ailettes horizontales 33 obtenues par usinage d'une pièce cubique ou cylindrique. Les ailettes se terminent par une embase 34 dimensionnée de manière à pouvoir s'insérer dans l'ouverture centrale de la pince 1. Dans ce cas, la pince est modifiée de telle sorte que chaque bras d'appui 28 comporte sur le bord externe de la zone d'appui un téton 35. Ce téton peut être réalisé en même temps que le bras d'appui correspondant ou constitué par une pièce rapportée, de préférence soudée sur le bras d'appui. Les tétons et au moins une des ailettes sont munis d'orifices 36, par exemple filetés, permettant de solidariser le radiateur sur la pince grâce à des vis 37. D'autres moyens de fixation connus de l'homme de l'art peuvent être envisagés.

La présente invention concerne aussi un dispositif d'encliquetage de la pince sur l'embase. Comme représenté sur la figure 8, ce dispositif est constitué par un couvercle 40 susceptible de venir s'emboîter sur l'embase du connecteur. Des bossages 41 sont prévus à l'intérieur du couvercle au niveau des quatre coins. Ces bossages sont destinés à venir en appui contre les quatre angles de la pince lors de l'encliquetage. De préférence, ce dispositif d'encliquetage 40 est moulé en matière plastique. Selon une variante de réalisation, une ouverture peut être prévue dans la partie centrale du fond du couvercle pour permettre le passage d'un radiateur.

Les chips-carrier à doubles rangées de plots alternés périmétriques ou à connexions surfaciques (« Open Via Chip-carrier » ou « Pad grid array » selon les dénominations anglo-saxonnes) c'est-à-dire comportant des contacts sur l'ensemble de l'une de ses faces peuvent être également utilisés avec une pince telle que décrite ci-dessus, l'embase comportant des contacts sur l'ensemble de sa surface. Autrement dit, le connecteur selon l'invention convient pour les chips-carrier à zones de contact ou connexions disposées périphériquement sur l'une et/ou les deux faces ainsi que ceux munis de connexions sur tout ou partie de la surface de leur face inférieure, avec ou sans connexions sur leur face supérieure. L'embase du connecteur sera bien entendu munie du nombre de contacts souples nécessaire pour assurer la liaison électrique avec les zones de contact ou connexions correspondantes du chip-carrier.

## Revendications

1. Connecteur à force d'insertion nulle pour support rectangulaire de circuit (5) ledit support étant muni de zones de contact disposées sur l'une au moins de ses deux faces et ledit connecteur comportant d'une part une embase rectangulaire (2) munie de contacts souples (3) sur lesquels viennent s'appuyer les zones de contact correspondantes de la face inférieure du support (5) et d'autre part une pince (1) constituée d'un cadre rectangulaire (28, 25) venant s'appuyer sur la partie supérieure du support (5), de manière à maintenir la continuité électrique entre les zones de contact et les contacts souples (3), ladite pince (1) étant fixée à l'embase (2) par des crochets (16) disposés aux quatre angles du cadre rectangulaire (28, 25) qui coopèrent avec des logements correspondants (6) de l'embase (2) et comportant au moins deux bras d'appui (28) disposés en vis-à-vis et reliés par deux bras de traverse (25), chaque bras d'appui (28) étant constitué sensiblement en son milieu d'une zone d'appui (20) à laquelle se raccordent deux demi-bras symétriques (18, 19) formant à l'état libre un V, l'extrémité desdits demi-bras (18, 19) située à proximité des crochets (16) étant à un niveau supérieur à la zone d'appui (20) lorsque la pince (1) est à l'état libre et sensiblement au même niveau que celle-ci (7) lorsque la pince (1) est fixée sur l'embase (2).

2. Connecteur selon la revendication 1, caractérisé en ce que les demi-bras (18, 19) ont une forme d'égale résistance.

3. Connecteur selon la revendication 2, caractérisé en ce que les demi-bras (18, 19) sont plus larges à proximité de la zone d'appui (20) qu'à proximité des crochets (16).

4. Connecteur selon l'une des revendications 1 à 3, caractérisé en ce que la zone d'appui (20) est formée par une excroissance (21) située sur le bord interne (23, 24) du bras d'appui (28) correspondant permettant une force d'appui de la pince (1) sur le support (5) supérieure à celle des contacts (3) de l'embase (2) sur ledit support (5).

5. Connecteur selon l'une des revendications 1 à 4, caractérisé en ce qu'au moins un des crochets (16) qui sont constitués d'une première partie (17) située dans le prolongement des demi-bras (18, 19), une seconde partie (13) sensiblement orthogonale à la première et une troisième partie (12) sensiblement orthogonale à la seconde (13) et qui coopèrent avec un logement (6) de l'embase (2) pour maintenir la fermeture de la pince, comporte un téton (14) dans le prolongement de la première partie (17) ménageant une ouverture (11) entre la seconde partie (13) et le téton (14) permettant l'introduction d'un outil plat venant en butée contre la troisième partie (12), l'ouverture du crochet s'effectuant à l'aide de l'outil plat prenant appui sur le téton (14) après son introduction dans l'ouverture (11).

6. Connecteur selon l'une des revendications 1 à 5, caractérisé en ce que les bras de traverse (25) de la pince ont une forme incurvée, dans le même sens que les bras d'appui, le bord interne (29) desdits bras (25) étant, lorsque la pince est à l'état libre, à un niveau inférieur à celui du bord extérieur du bras correspondant (25).

7. Connecteur selon l'une des revendications 1 à 6, caractérisé en ce que l'embase (2) comporte aux quatre coins des parties en relief situées en retrait du pourtour extérieur de l'embase (2) et possédant une rampe (8) sur laquelle vient glisser le crochet (16) correspondant de la pince (1) lors de l'accouplement pince (1) — embase (2), ladite rampe (8) se terminant par une partie plane (6) sur laquelle vient s'appuyer la troisième partie (15) du crochet (16) correspondant.

8. Connecteur selon l'une des revendications 1 à 7, caractérisé en ce que chaque bras d'appui (28) comporte sur le bord externe de la zone d'appui (20), un téton (35) permettant la fixation d'un dispositif de refroidissement.

9. Dispositif d'encliquetage de la pince sur l'embase d'un connecteur selon l'une quelconque des revendications 1 à 8, caractérisé en ce qu'il est constitué par un couvercle de forme parallélépipédique de manière à s'emboîter sur l'embase, ledit couvercle comportant intérieurement des bossages prévus au niveau des coins.

## Claims

1. Zero-force insertion connector for rectangular circuit support (5), said support being provided with contact zones situated on at least one of its two faces and said connector comprising, on the one hand, a rectangular base (2) equipped with flexible contacts (3) on which rest the corresponding contact zones of the lower face of the support (5) and on the other hand, a clamp (1) constituted of a rectangular frame (28, 25) which can rest on the upper part of the support (5), so as to maintain electrical conduction between the contact zones and the flexible contacts (3), said clamp (1) being fixed to the base (2) by hooks (16) provided at the four angles of the rectangular frame (28, 25), which hooks are engageable in corresponding recesses (6) provided in the base (2), and comprising at least two bearing arms (28) placed in facing relationship with respect to each other and interconnected by means of two cross-arms (25), each bearing arm (28) being constituted, substantially in its middle part, of a bearing zone (20) with which are joined two symmetrical half-arms (18, 19) forming a V in the released condition, the end of said half-arms (18, 19) situated close to the hooks (16) being at a level higher than the bearing zone (20) when the clamp (1) is in released condition, and on substantially the same level as said zone (7) when the clamp (1) is fixed on the base (2).

2. Connector according to claim 1, characterized in that the half-arms (18, 19) have a shape of equal resistance.

3. Connector according to claim 2, characterized in that the half-arms (18, 19) are wider close to the bearing zone (20) than close to the hooks (16).

4. Connector according to one of claims 1 to 3, characterized in that the bearing zone (20) is formed by an extension (21) situated on the inner edge (23, 24) of the corresponding bearing arm (28) enabling the clamp (1) to bear on the support (5) with a force higher than that with which the contacts (3) of the base (2) bear on said support (5).

5. Connector according to one of claims 1 to 4, characterized in that at least one of the hooks (16) which are constituted of a first part (17) extending from said half-arms (18, 19), a second part (13) substantially perpendicular to the first and a third part (12) substantially perpendicular to the second (13) and which cooperate with a recess (6) of the base (2) in order to keep the clamp closed, comprises a lug (14) extending from the first part (17) and providing an opening (11) between the second part (13) and the lug (14) for introducing a flat tool abutting against the third part (12), the hook being opened by means of the flat tool bearing against the lug (4) after its introduction into the opening (11).

6. Connector according to one of claims 1 to 5, characterized in that the cross-arms (25) of the clamp have a curved shape, curving in the same direction as the bearing arms, the inner edge (29) of said arms (25) being, when the clamp is in released condition, at a lower level than the outer edge of the corresponding arm (25).

7. Connector according to one of claims 1 to 6, characterized in that the base (2) comprises in its four corners, projecting portions situated in offset relationship with respect to the outer periphery of the base (2) and having a ramp (8) on which the corresponding hook (16) of the clamp (1) slides when the clamp (1) and the base (2) join up, said ramp (8) ending into a flat portion (6) on which rests the third part (15) of the corresponding hook (16).

8. Connector according to one of claims 1 to 7, characterized in that each bearing arm (28) comprises, on the outer edge of the bearing zone (20), a lug (35) for fixing a cooling device.

9. Device for interlocking the clamp on the base of a connector according to any one of claims 1 to 8, characterized in that it is constituted by a cover of parallelepipedal shape so as to fit over the base, said cover being provided internally with bosses situated at the level of the corners.

**Patentansprüche**

1. Verbinder mit kräftefreier Einfügung für einen rechteckigen Schaltungsträger (5), wobei der genannte Träger Kontaktzonen aufweist, die auf mindestens einer seiner beiden Stirnseiten angeordnet sind, wobei der genannte Verbinder einerseits einen rechteckigen Sockel (2) aufweist, der biegsame Kontakte (3) besitzt, auf denen die entsprechenden Kontaktzonen der Unterseite des Trägers (5) in Anlage kommen, und andererseits eine Klammer·(1) aufweist, die durch einen rechteckigen Rahmen (28, 25) gebildet wird, und die auf der Oberseite des Trägers (5) in der Art und Weise in Anlage kommt, daß die elektrische Verbindung zwischen den Kontaktzonen und den biegsamen Kontakten erhalten bleibt, wobei die genannte Klammer (1) am Sockel (2) durch Haken (16) befestigt ist, die an den vier Ecken des rechteckigen Rahmens (28, 25) angeordnet sind und mit entsprechenden Ausnehmungen (6) des Sockels (2) in Eingriff kommen und mindesten zwei gegenüberliegend angeordnete und durch zwei Querarme (25) verbundene Anlagearme (28) aufweist, deren jeder zweckmäßigerweise in seiner Mitte eine Anlagezone (20) bildet, an der zwei symetrische im freien Zustand ein V bildende Halbarme (18, 19) verbunden sind, wobei dann wenn die Klammer (1) sich in ihrem freien Zustand befindet die Enden der Halbarme (18, 19) in der Nähe der Haken (16) auf einem höheren Niveau als das der Anlagezone (20) angeordnet sind, während dann, wenn die Klammer (1) auf dem Sockel (2) befestigt ist, die Enden der Halbarme (18, 19) sich auf dem gleichen Niveau wie das von (7) befinden.

2. Verbinder nach Anspruch 1, dadurch gekennzeichnet, daß die Halbarme (18, 19) eine die gleiche Widerstandskraft aufweisende Form besitzen.

3. Verbinder nach Anspruch 2, dadurch gekennzeichnet, daß die Halbarme (18, 19) in der Nähe der Anlagezone (20) breiter sind als in der Nähe der Haken (16).

4. Verbinder nach einem der Ansprüche 1-3, dadurch gekennzeichnet, daß die Anlagezone (20) durch einen Höcker (21) gebildet ist, und zwar angeordnet auf der Innenseite (23, 24) des entsprechenden Anlagearms (28), was eine Anlagekraft der Klammer (1) am Träger (5) ermöglicht, die größer ist als die der Kontakte (3) des Sockels (2) am Träger (5).

5. Verbinder nach einem der Ansprüche 1-4, dadurch gekennzeichnet, daß die haken (16), gebildet sind durch einen ersten in der Verlängerung der Halbarme (18, 19) liegenden Teil (17), einen zweiten zweckmäßigerweise senkrecht zum ersten Teil verlaufenden Teil (13) und einen dritten zweckmäßigerweise senkrecht zum zweiten Teil (13) verlaufenden Teil (12), der mit einer Ausnehmung (6) des Sockels (2) in Eingriff kommt, um die Schließung der Klammer (1) aufrechtzuerhalten, wobei mindestens einer der Haken (16) in der Verlängerung des ersten Teils (17) einen Vorsprung (14) aufweist, der zwischen dem zweiten Teil (13) und dem Vorsprung (14) eine Öffnung (11) bildet, welche das Einsetzen eines flachen Werkzeugs gestattet, welches am dritten Teil (12) zur Anlage kommt, wobei die Öffnung der Klammer mit Hilfe des am Vorsprung (14) zur Anlage kommenden flachen Werkzeugs nach seiner Einführung in die Öffnung (11) bewirkt wird.

6. Verbinder nach einem der Ansprüche 1-5, dadurch gekennzeichnet, daß die Querarme (25) der Klammer eine einwärts gekrümmte Form besitzen, und zwar im gleichen Sinne wie die Anlagearme, wobei die Innenseite (29) der Arme (25) im freien Zustand der Klammer auf einem niedrigerem Niveau liegt, als das Niveau der außenseiten der entsprechenden Arme (25).

7. Verbinder nach einem der Ansprüche 1-6, dadurch gekennzeichnet, daß der Sockel (2) an vier Ecken Ausnehmungsteile aufweist, zurückgenommen am Außenumfang des Sockels (2) und ausgestattet mit einer Rampe (8) auf der die entsprechenden Haken (16) der Klammer (1) gleiten, und zwar während der Kupplung von Klammer (1) und Sockel (2), wobei die Rampe (8) in einem ebenen Teil (6) endet, auf dem der dritte Teil (12) des entsprechenden Hakens (16) zur Anlage kommt.

8. Verbinder nach einem der Ansprüche 1-7, dadurch gekennzeichnet, daß jeder Anlagearm (28) auf der Innenseite der Anlagezone (20) einen Vorsprung (35) aufweist, der die Befestigung einer Kühlvorrichtung ermöglicht.

9. Einklinkvorrichtung der Klammer auf dem Sockel eines Verbinders nach einem der Ansprüche 1-8, dadurch gekennzeichnet, daß sie durch einen Deckel in der Form eines Parallelepipeds derart gebildet wird, daß sie sich auf dem Sockel einfügt, wobei der Deckel im Inneren auf der Höhe der Ecken Vorsprünge aufweist.

# FIG_1-A

# FIG_1-B

FIG_5

FIG_4

FIG_3

FIG_2

2

# FIG_6

# FIG_7

# FIG_8